# EUROPÄISCHE PATENTSCHRIFT

(11) **EP 3 667 873 B1**
(45) Veröffentlichungstag und Bekanntmachung des Hinweises auf die Patenterteilung: **23.03.2022**
(21) Anmeldenummer: 18020634.4
(22) Anmeldetag: 10.12.2018
(51) Int. Cl.: H02K 5/22, H01L 23/31, H01L 23/373, H01L 23/552, H02K 11/22, H05K 5/00, H02K 7/14, H02K 9/22, H02K 15/14, H02K 11/33, H05K 9/00, H05K 7/14, F04D 13/06, F04D 29/58, H05K 7/20, H02K 11/01, H02K 11/02

(54) **PUMPENELEKTRONIK**
PUMP ELECTRONICS
ÉLECTRONIQUE DE LA POMPE

(43) Veröffentlichungstag der Anmeldung: 17.06.2020
(73) Patentinhaber: WILO SE, 44263 Dortmund (DE)
(72) Erfinder: KIEL, Martin, 44263 Dortmund (DE); BROCKMANN, Markus, 44263 Dortmund (DE); BLÖCKER, Gerrit, 44263 Dortmund (DE); JÄGER, Nils, 44263 Dortmund (DE); KÜSTER, Bernd, 44263 Dortmund (DE); SCHMELTER, Tina, 44263 Dortmund (DE)
(74) Vertreter: Cohausz Hannig Borkowski Wißgott

(56) Entgegenhaltungen:
- EP-A1- 1 643 818
- EP-A1- 2 618 004
- EP-A1- 2 750 267
- EP-A1- 2 863 725
- EP-A1- 2 905 888
- US-A- 5 285 619
- US-A1- 2010 176 534
- US-A1- 2012 057 388
- US-A1- 2017 027 058

## Beschreibung

Die vorliegende Erfindung betrifft eine Pumpenelektronik einer elektromotorisch angetriebenen Kreiselpumpe, mit einem Elektronikgehäuse, in dem eine Steuer- und/ oder Regelungselektronik mit einem Frequenzumrichter zur Drehzahlregelung der Kreiselpumpe angeordnet ist, wobei die Steuer- und/oder Regelungselektronik zumindest eine Leiterplatte mit elektrischen und/oder elektronischen Bauelementen aufweist, die wenigstens eine Drossel und Halbleiterschalter umfassen und von einer elektromagnetischen Abschirmung umgeben sind.

Steuer- und/ oder Regelungselektroniken drehzahlgeregelter Kreiselpumpen sind heutzutage komplexe Erzeugnisse. Sie haben elektrische und elektronische Bauteile wie Drosseln, Dioden, Transistoren, die einerseits elektromagnetische Interferenzen erzeugen und daher aus EMV Gründen (Elektromagnetische Verträglichkeit) abgeschirmt werden müssen, und die andererseits erhebliche Abwärme erzeugen, die abgeführt werden muss, damit ihre Leistungsfähigkeit nicht beeinträchtigt wird und sie nicht überhitzen, schlimmstenfalls zerstört werden.

Elektromagnetische Abschirmungen werden beispielsweise in Form von gelochten oder ungelochten Blechen realisiert, die die Bauelemente abdecken. Die Kühlung kann aktiv über Kühlelemente wie Lüfter, Peltiers oder Heatpipes erfolgen, oder passiv über Kühlkörper. In der Regel werden für eine gute thermische Verbindung spaltüberbrückende Kontaktpads oder Wärmeleitpaste verwendet. Auch sind Schrauben und andere metallische Befestigungselemente nötigt, um die Bauelemente, Abschirmungen und Kühlelemente örtlich mechanisch zu befestigen und miteinander zu verbinden. Gleichzeitig muss die elektrische Verbindung zwischen den Bauelementen und weiteren Komponenten der Steuer- und/ oder Regelungselektronik realisiert werden. Zur Entwicklung und Herstellung einer Pumpenelektronik sind deshalb eine Vielzahl einzelner Entwicklungs- und Fertigungsschritte erforderlich.

Von besonderem Nachteil ist es, dass die Wärme und Interferenzen erzeugenden Bauteile auf der oder den Leiterplatten der Steuer- und/ oder Regelungselektronik oft verteilt sind, d.h. weit auseinanderliegen, weil aufgrund der unterschiedlichen Bauformen verschiedene Montagearten und Lötverfahren wie THT (Through Hole Technology, Durchsteckmontage mit Hand- oder Wellenlöten) oder SMD (Surface Mounted Device, Oberflächenmontage mit Verlöten im Ofen) zur Anwendung kommen. Es müssen deshalb mehrere Einzelmaßnahmen zur Kühlung und Abschirmung vorgenommen werden, d.h. beispielsweise mehrere kleine Kühlkörper oder Abschirmbleche, was den Fertigungsaufwand und die Herstellungskosten erhöht. Alternativ kann eine gesamtheitliche Maßnahme gewählt werden, beispielsweise eine großflächige elektromagnetische Abschirmung, um alle relevanten Bauelemente zu erfassen, z.B. eine Abschirmung der kompletten Elektronik, oder ein sehr großer Kühlkörper, an den alle wärmeerzeugenden Bauelemente angebunden sind. Dies führt jedoch ebenfalls zu hohen Kosten. Ein solcher Kühlkörper wird in der Praxis ferner überdimensioniert sein. Ganzheitliche Lösung erhöhen ferner den Bauraum und schränken die Gestaltungsfreiheit der Elektronik erheblich ein.

Die europäische Patentanmeldung EP 2 618 004 A1 offenbart eine elektrische Pumpe mit einer Pumpenelektronik, die in einem Gehäuse vergossen ist, wobei die Vergussmasse thermisch leitfähig ist. Eine elektromagnetische Abschirmung nennt die Schrift nicht, jedoch kann das Gehäuse aus Aluminium sein.

Die US Anmeldung 2012/0057388 A1 beschreibt einen Wechselrichter zur Verwendung mit Photovoltaikmodulen, wobei dieser zur EMV-Abschirmung in einem zweischaligen Gehäuse aus Metall angeordnet ist.

Das US Patent 5,285,619 beschreibt ein Verfahren zum Schützen einer Elektronik, bei dem die Elektronik in einem Schrumpfschlauch angeordnet und mit einem Polymer vergossen wird, wobei diese Anordnung anschließend Hitze ausgesetzt wird, damit der Schrumpfschlauch schrumpft.

Weiterhin offenbart die US Anmeldung 2017/0027058 A1 das Verpacken elektrischer Komponenten eines Geräts, wobei eine Kappe diese Komponenten abdeckt. Eine Metallschicht auf der Oberfläche der Kappe kann strukturiert sein, um eine elektromagnetische Abschirmung, Signalwege, Kontaktflächen, Sensorelektroden, Antennen und andere Strukturen zu bilden. EP2905888 beschreibt einen weiteren Pumpenelektronik mit einer elektromagnetischen Abschirmung und EP2863725 beschreibt eine Leiterplatte, die auf einer Seite mit einer wärmeleitenden Masse beschichtet ist.

Es ist Aufgabe der vorliegenden Erfindung, eine Pumpenelektronik bereitzustellen, die eine verbesserte räumliche und funktionale Anordnung von Wärme und elektromagnetische Interferenzen erzeugenden Bauelemente bei gleichzeitig verbesserter Kühlung und Abschirmung dieser Bauteile aufweist.

Diese Aufgabe wird durch eine Pumpenelektronik mit den Merkmalen des Anspruchs 1 gelöst. Vorteilhafte Weiterbildungen sind in den Unteransprüchen angegeben und werden nachfolgend erläutert.

Erfindungsgemäß ist vorgesehen, eine gattungsgemäße Pumpenelektronik dahingehend weiterzubilden, dass die Bauelemente, d.h. wenigstens eine Drossel und Halbleiterschalter, mitsamt der Leiterplatte in einer thermisch leitfähigen und elektrisch isolierenden Vergussmasse eingebettet sind und gemeinsam einen Vergusskörper bilden, der innerhalb des Elektronikgehäuses angeordnet ist, wobei die Abschirmung in den Vergusskörper integriert ist.

Ein wesentlicher Aspekt der Erfindung ist die räumliche Verdichtung der Wärme und Interferenzen erzeugenden Bauteile. Hierdurch wird die Elektronik kompakter und ein hohes Maß an Funktionsintegration erreicht. Die Wärmeabfuhr und Interferenzabschirmung erfolgt unmittelbar am Ort ihrer Entstehung und ist daher besonders effektiv. Hieraus folgt, dass die Bauelemente mehr elektromagnetische Interferenz erzeugen dürfen, so dass die Anzahl und Größe der Filterkomponenten reduziert werden kann. Es wird einerseits Bauraum eingespart, und die Pumpenelektronik kann andererseits kleinbauender ausgeführt werden. Durch das direkte Einbetten der Bauelemente in die Vergussmasse kann Abwärme von allen Seiten der Bauelemente aufgenommen und effektiv abgeführt werden. Durch die hiermit erreichte verbesserte Kühlung wird die Effizienz der Bauelemente erhöht, weil bei diesen keine temperaturabhängige Leistungsbegrenzung mehr vorgenommen werden muss. Bei konventioneller Kühlung ist dies erforderlich, um eine Überhitzung zu vermeiden, wobei hierzu die Leistung bei Erreichen einer Grenztemperatur limitiert wird.

Der durch das Einbetten der Bauelemente hergestellte Vergusskörper bildet eine Baugruppe, die innerhalb der Pumpenelektronik angeordnet wird. Es ist also nicht etwa vorgesehen, die gesamte Pumpenelektronik zu vergießen. Vielmehr werden nur solche oder diejenigen Bauelemente der Steuer- und/ oder Regelungselektronik eingebettet, die abzuführende Wärme und elektromagnetische Strahlung emittieren. Insbesondere betrifft dies die Leistungselektronik der Pumpenelektronik, wie z.B. Komponenten des Frequenzumrichters, welcher die Drehzahl der Kreiselpumpe einstellt, und/ oder die Schaltung zur Leistungsfaktorkorrektur (PFC Power Factor Control), welche die Netzrückwirkung minimiert. Die einzubettenden Halbleiterschalter können beispielsweise diejenigen des Gleichrichters, z.B. Dioden, und/ oder diejenigen des Wechselrichters, z.B. MOSFETS sein. Ferner kann es sich bei der Drossel, um die PFC- Drossel der PFC-Schaltung handeln. Ferner kann auch ein oder können mehrere Halbleiterschalter der PFC-Schaltung eingebettet werden.

Zusätzlich kann vorgesehen sein, dass ein oder mehrere Sensoren in der Vergussmasse eingebettet werden, beispielsweise Temperatursensoren, um die Temperatur im Vergusskörper überwachen zu können.

Durch die Kombination der Bauelemente zu einer funktionsintegrierten Baugruppe werden Entwicklungsschritte (Design Loops) reduziert insbesondere um die erforderliche EMV der gesamten Pumpenelektronik zu erreichen, wodurch sich auch die Entwicklungszeit verkürzt. Ferner werden die Fertigungsschritte verringert. Es sind keine Einzelabschirmungen und auch keine Einzelkühlungen für die Bauelemente nötig. Die Herstellungskosten werden reduziert und der Aufbau der Pumpenelektronik vereinfacht.

Gemäß einer ersten Ausführungsvariante kann der Vergusskörper ein becherförmiges, aus einem Kunststoff spritzgegossenes Modulgehäuse aufweisen, innerhalb welchem die Bauelemente mit der Vergussmasse vergossen sind. Vorzugsweise ist dieser Kunststoff thermisch leitfähig. Das Modulgehäuse bildet in dieser Ausführungsvariante somit ein Behältnis, das nicht nur als Aufnahme für die Leiterplatte und deren Bauteile dient, sondern gleichzeitig als Gießform dient, welches mit der Vergussmasse verbunden bleibt und Bestandteil des Vergusskörpers wird. Das Modulgehäuse wird in einem ersten Spritzvorgang hergestellt, anschließend erfolgt in einem zweiten Schritt das Vergießen der Bauelemente.

Gemäß einer zweiten Ausführungsvariante kann der Vergusskörper zwar ebenfalls ein Modulgehäuse aus einem thermisch leitfähigen Kunststoff aufweisen, jedoch ist dieser Kunststoff außen an die Vergussmasse angespritzt. Somit werden die Bauelemente zunächst in der Vergussmasse eingebettet, beispielsweise durch deren Vergießen in einer Gießform eines Werkzeugs, und anschließend wird das Modulgehäuse um die gehärtete Vergussmasse herumgespritzt. Dieses Umspritzen kann beispielsweise mit dem sogenannten zwei Komponenten (2K) Spritzgießen durchgeführt werden.

Die Vergussmasse ist vorzugsweise ein Duroplast. Dies hat den Vorteil, dass die Bauelemente nicht den vergleichsweise hohen Temperaturen einer thermoplastischen Kunststoffschmelze ausgesetzt werden müssen. Zudem können Duroplaste, beispielsweise im Falle von Kunstharzen, vergleichsweise flüssig sein, so dass sie drucklos gegossen werden können und nicht mit Druck gespritzt werden müssen. Dabei werden gleichwohl auch kleinste Zwischenräume ausgefüllt, so dass keine Luftblasen, welche Wärmebarrieren bilden, in der Vergussmasse verbleiben. Um dies zu verbessern kann das Vergießen im Vakuum erfolgen. Luftblasen werden dadurch aus der Vergussmasse herausgetrieben.

Demgegenüber kann das Modulgehäuse aus einem Thermoplast hergestellt sein. Vorzugsweise kann ein Thermoplast verwendet werden, das eine EMV Abschirmung besitzt. So kann auf zusätzliche Abschirmungsmaßnahmen verzichtet werden. Bei den bevorzugten Wandstärken lassen sich mit einem Thermoplast kürzere Zykluszeiten beim Spritzgießprozess realisieren.

Sinnvollerweise ist die Vergussmasse elektrisch isolierend, so dass kein elektrischer Kontakt zwischen den eingebetteten Bauteilen hergestellt wird und die zugänglichen elektrischen Kontaktstellen der Bauelemente und Leiterplatte auch nicht vor der Vergussmasse geschützt werden müssen.

Gemäß einer dritten Ausführungsvariante kann der Vergusskörper gehäuselos ausgebildet sein. Dies bedeutet, dass die Außenseite der ausgehärteten Vergussmasse auch die Außenseite des Vergusskörpers bildet, also frei liegt. Die Herstellung des Vergusskörpers kann in einer Gießform oder Spritzgießform eines entsprechenden Werkzeugs durch Gießen oder Spritzgießen mit der Vergussmasse erfolgen. Die Vergussmasse kann auch hier bevorzugt ein Duroplast sein, idealerweise ein elektrisch isolierender Kunststoff oder synthetisches Harz.

Die elektromagnetische Abschirmung der Bauelemente kann auf unterschiedliche Weise erfolgen.

Beispielsweise kann die Abschirmung durch ein metallisches Vlies gebildet sein. In der ersten Ausführungsvariante kann das Modulgehäuse an das Vlies angespritzt sein, so dass es innen- oder außenseitig am Modulgehäuse anliegt. Das Vlies bildet somit ein Einlegeteil, das in die Spritzgießform (Kavität) zur Herstellung des becherförmigen Modulgehäuses eingelegt wird, welche anschließend mit dem Kunststoff gefüllt wird, wodurch der Kunststoff das Vlies benetzt und je nach Anordnung des Vlieses durch den Fließdruck gegen die innere oder äußere Kavitätswand drückt.

In der zweiten Ausführungsvariante kann das Vlies vordem Vergießen der Bauelemente in das Modulgehäuse eingelegt werden, so dass es zwischen der Vergussmasse und dem Modulgehäuse liegt. Es wird dann durch das Vergießen der Bauelemente gegen die Innenwand des Modulgehäuses gedrückt.

Auch in der dritten Variante kann die Abschirmung durch ein metallisches Vlies gebildet sein. Dieses wird hier mit der Vergussmasse derart vergossen, dass es außenseitig am Vergusskörper anliegt. Hierzu kann das Vlies in die Gießform oder Spritzgießform des Werkzeugs eingelegt werden, welches die Form anschließend mit der Vergussmasse füllt, die das Vlies durch den Fließdruck gegen die Wand der Form drückt.

In jedem der Fälle ergibt sich ein formschlüssiger Verbund zwischen den Fasern des Vlieses und dem Kunststoff des Modulgehäuses oder der Vergussmasse.

Es ist allerdings bei keiner der Varianten nötig, dass die Abschirmung, insbesondere das Vlies, an allen Seiten des Modulgehäuses vorgesehen wird. An denjenigen Flächen des Modulgehäuses, die an einer metallischen Wand, beispielsweise des Elektronikgehäuses anliegen, kann auf die Abschirmung verzichtet werden, da diese Wand bereits eine Abschirmung bewirkt. Dies führt im Falle des Vlieses zu einer einfacheren Verarbeitung des Vlieses, da sich das Vlies dann nicht so leicht faltet, was wiederum die Prozesssicherheit verbessert.

Die Verarbeitung des Vlieses ist bei der ersten Variante besonders einfach, wenn es die Form und Größe des Innenraums des Modulgehäuses nachbildend gefaltet in dem Modulgehäuse einliegt. Durch die Faltung ist das Vlies formstabil und kann leicht in das Modulgehäuse eingesetzt werden, wo es während des Vergießens in Position verbleibt. Vorzugsweise können seitliche Laschen von Flächenabschnitten des Vlieses andere Flächenabschnitte des Vlieses überlappen. Dies hat den Vorteil, dass keine elektromagnetische Strahlung an den Kanten des Vlieses heraustritt.

In der Ausführungsvariante, bei der das Vlies vom Kunststoff des Modulgehäuses angespritzt bzw. umspritzt wird, kann das Vlies auf einen den Hohlraum im Modulgehäuse ausbildenden Kern aufgesteckt (innenliegende Variante) oder in die Kavität zur Ausbildung des Modulgehäuses eingelegt werden (außenliegend Variante). In der Ausführungsvariante, bei der die Bauteile vergossen werden, kann das Vlies in das Modulgehäuse oder in die Kavität, die den Vergussraum begrenzt, eingelegt werden. Dies ist beim Umspritzen genauso.

In einer alternativen Weiterbildung kann die Abschirmung durch eine elektrisch leitende Beschichtung gebildet sein. Diese kann z.B. metallisch sein. Sie kann innen- oder außenseitig auf das Modulgehäuse oder außenseitig auf die Vergussmasse aufgebracht sein. Das Aufbringen kann beispielsweise durch Besprühen, Tauchbaden oder Abscheiden der Beschichtung auf dem Modulgehäuse oder der Vergussmasse erfolgen.

Als weitere Alternative kann die Abschirmung durch Leiterbahnen, insbesondere ein Netz von Leiterbahnen gebildet sein. Diese können ebenfalls innen- oder außenseitig auf das Modulgehäuse aufgebracht sein. Das Aufbringen kann beispielsweise mit dem sogenannten IMKS Verfahren (Integriertes Metall Kunststoff Spritzgießen) erfolgen.

Gemäß einer weiteren Alternative kann die Abschirmung durch ein metallisches Einlegeteil gebildet sein. Beispielsweise kann das Einlegeteil in Form eines Gitters, Lochblechs, Netzes oder Gewebes vorliegen und insbesondere formstabil sein. Durch das Spritzgießen des Modulgehäuses kann das Einlegeteil in den das Modulgehäuse bildenden Kunststoff eingebettet werden, so dass es mit einem Modulgehäuse einstückig wird und ist. Alternativ kann das Einlegeteil durch das Vergießen der Bauelemente in der Vergussmasse eingebettet sein oder werden, so dass es mit der Vergussmasse einstückig wird.

Von besonderem Vorteil ist es, wenn ein Abschnitt des Einlegeteils aus dem Vergusskörper, d.h. aus dem Modulgehäuse oder aus der Vergussmasse hervorsteht. Dieser Abschnitt bildet eine Anschlussfahne, mit welcher der Vergusskörper elektrisch oder thermisch leitend mit einer weiteren Komponente des Elektronikgehäuses verbunden werden kann. Da das Einlegeteil aus Metall besteht, hat es einen sehr hohen Wärmeleitkoeffizienten, so dass es die Wärme optimal aus der Vergussmasse heraustransportieren kann. In diesem Fall braucht der Kunststoff des Modulgehäuses nicht thermisch leitfähig zu sein.

Idealerweise ist das Einlegeteil mit der Fahne thermisch leitend mit einer Wärmesenke, insbesondere mit einer metallischen Wand des Elektronikgehäuses verbunden, vorzugsweise verschraubt. Alternativ oder in Kombination kann das Einlegeteil über den Abschnitt elektrisch mit Masse verbunden sein.

Messungen haben gezeigt, dass bei komplett umspritzten Bauelementen die Temperaturen der Bauelemente aufgrund der Wärmeaufnahmekapazität der Vergussmasse derart gesenkt werden, dass keine externe Wärmesenke vorhanden sein muss.

Gemäß einer weiteren Alternative kann der das Modulgehäuse bildende Kunststoff Partikel enthalten, die die elektromagnetische Abschirmung bewirken. Dies können beispielweise Stahlfasern sein oder kohlenstoffbasierte Füllstoffe (sog. Leitfähigkeitsruß).

Bevorzugt kann die Leiterplatte rechtwinklig zu einer Öffnung des Modulgehäuses angeordnet sein, durch die die Leiterplatte in das Modulgehäuse eingesetzt ist. Die Leiterplatte liegt somit in Gießrichtung. Es werden zu beiden Seiten der Leiterplatte Freiräume gebildet, die mit der Vergussmasse einfach und vollständig gefüllt werden können. Die Leiterplatte versperrt oder behindert somit die Vergussmasse nicht.

Idealerweise ist die Drossel durch eine Ringkerndrossel gebildet. Vorzugsweise ist diese liegend auf der Leiterplatte montiert, so dass ihr Durchmesser parallel zur Leiterplatte verläuft. Die Drossel steht somit nicht auf der Leiterplatte, wodurch eine kompakte Bauform des Vergusskörpers erreicht wird. Die notwendigen Abmessungen des Vergusskörpers werden des Weiteren dadurch gering gehalten, dass die Bauelemente auf beiden Seiten der Leiterplatte angeordnet sind. Beispielsweise können die Drossel auf einer ersten Seite der Leiterplatte und die Halbleiterschalter auf der anderen Seite der Leiterplatte angeordnet sein.

Vorzugsweise sind auf der Leiterplatte elektrische Leiterbahnen ausgebildet, die die Drossel und/ oder zumindest einen Teil der Halbleiterbauelemente miteinander verbinden. Somit ist die Leiterplatte nicht nur mechanischer Träger der Bauelemente. Sie trägt oder bildet vielmehr gleichzeitig eine Verschaltung der Bauelemente.

Um die Leiterplatte respektive die Bauelemente einfach kontaktieren zu können, ragt die Leiterplatte aus einer Öffnung des Modulgehäuses mit elektrischen Kontaktflächen heraus. Bei dieser Öffnung kann es sich um die Einfüllöffnung für die Vergussmasse handeln, durch die auch die Leiterplatte in das Modulgehäuse eingesetzt ist. Die Kontaktfläche können in Gestalt von Randkontakten auf einer oder beiden Oberflächen der Leiterplatte ausgebildet sein, insbesondere eine kammartige Struktur derart bilden, dass zwischen den Kontaktflächen Ausnehmungen in der Leiterplatte vorhanden sind.

Zur Erreichung einer besonders guten Wärmeableitung aus dem Vergusskörper ist es von Vorteil, wenn diese flächig an zumindest einer metallischen Wand des Elektronikgehäuses thermisch leitend anliegt. Die Wand dient dann als Wärmesenke und nimmt die Wärme des Vergusskörpers auf, so dass der Vergusskörper effektiv gekühlt wird.

Um eine gute Verteilung der Vergussmasse zu erreichen, kann die Leiterplatte Durchtrittsöffnungen für das Hindurchtreten der Vergussmasse beim Vergießen der Bauelemente aufweisen. Somit kann die flüssige Vergussmasse durch die Leiterplatte hindurch von der Seite zur anderen Seite der Leiterplatte fließen. Im ausgehärteten Zustand liegt die Vergussmasse somit auch in den Durchtrittsöffnungen ein.

Damit das Einlegeteil zur Einbettung in der Vergussmasse relativ zur Leiterplatte ortsfest gehalten wird und seine Position und/ oder Ausrichtung beim Gießen oder Spritzgießen der Vergussmasse nicht ändert, kann das Einlegeteil mechanisch an der Leiterplatte gehalten sein. Hierzu können in der Leiterplatte Halteöffnungen vorgesehen sein, in welche das Einlegeteil mit entsprechenden Befestigungsabschnitten fest einliegt.

Der Vergusskörper kann in seinem Inneren ferner mitvergossene Halteelemente zur ortsfesten Halterung der Leiterplatte in der Gießform oder Spritzgießform eines Gießwerkzeugs. Diese Halterungen können beispielsweise stiftförmig sein und sich durch Halteöffnungen hindurchstrecken, so dass die Halteelemente auf einer oder auf beiden Seiten der Leiterplatte vorstehen, so dass sich diese an den Wänden der Gießform oder Spritzgießform abstützt. Beim Gießen oder Spritzgießen der Vergussmasse umschließt diese auch die Halteelemente, so dass diese dauerhaft im Vergusskörper verbleiben.

Weitere Merkmale, Wirkungen und Vorteile der Erfindung werden nachfolgend anhand von Ausführungsbeispielen und der beigefügten Figuren erläutert. Es zeigen:
- Fig. 1:: einen Teil einer Pumpenelektronik mit Elektronikgehäuse und Vergusskörper
- Fig. 2:: einen Vergusskörper mit Modulgehäuse
- Fig. 3:: einen gehäuselosen Vergusskörper
- Fig. 4:: ein metallisches Vlies
- Fig. 5:: das Modulgehäuse mit darin gefaltet eingelegtem Vlies
- Fig. 6:: die zu vergießende Leiterplatte mit Bauelementen
- Fig. 7:: die Leiterplatte im in das mit dem Vlies ausgelegten Modulgehäuse eingesetzten Zustand
- Fig. 8:: Prinzipdarstellung einer ersten Ausführungsvariante des Vergusskörpers mit Modulgehäuse und innenseitigem Vlies als elektromagnetische Abschirmung
- Fig. 9:: Prinzipdarstellung einer zweiten Ausführungsvariante des Vergusskörpers mit Modulgehäuse und innenseitiger Metallbeschichtung als elektromagnetische Abschirmung
- Fig. 10:: Prinzipdarstellung einer vierten Ausführungsvariante des Vergusskörpers mit umspritzten Einlegeteil im Modulgehäuse als elektromagnetische Abschirmung
- Fig. 11:: Einlegeteil in Gestalt eines wabenförmigen Metallgitters
- Fig. 12:: Prinzipdarstellung einer fünften Ausführungsvariante des Vergusskörpers ohne Gehäuse mit außenseitigem Vlies als elektromagnetische Abschirmung
- Fig. 13:: Prinzipdarstellung einer sechsten Ausführungsvariante des Vergusskörpers ohne Gehäuse mit außenseitiger Metallbeschichtung als elektromagnetische Abschirmung
- Fig. 14:: Prinzipdarstellung einer achten Ausführungsvariante des Vergusskörpers mit Partikeln im Modulgehäuse zur elektromagnetischen Abschirmung
- Fig. 15:: Prinzipdarstellung einer neunten Ausführungsvariante des Vergusskörpers ohne Gehäuse mit umspritzten Einlegeteil in der Vergussmasse als elektromagnetische Abschirmung
- Fig. 16:: perspektivische Darstellung eines Modulgehäuses mit außenseitig aufgebrachten Leiterbahnen in IMKS Technik

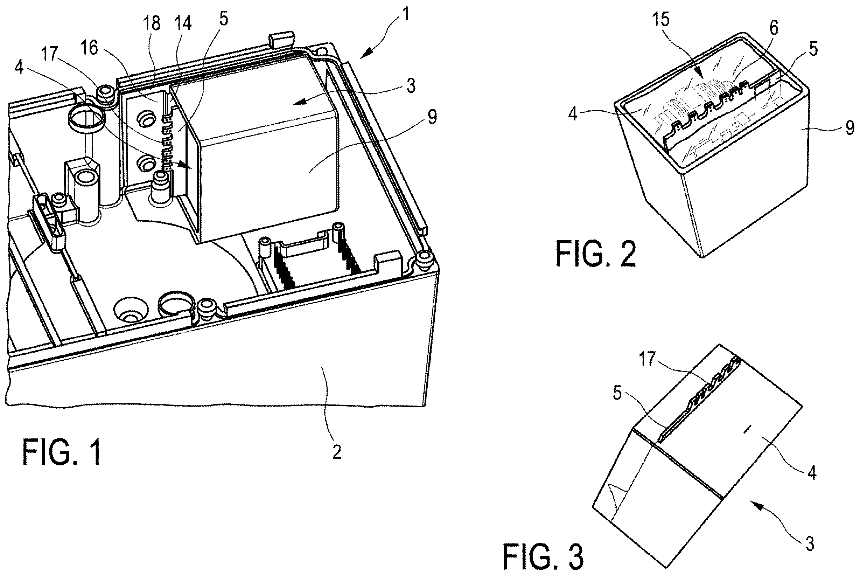

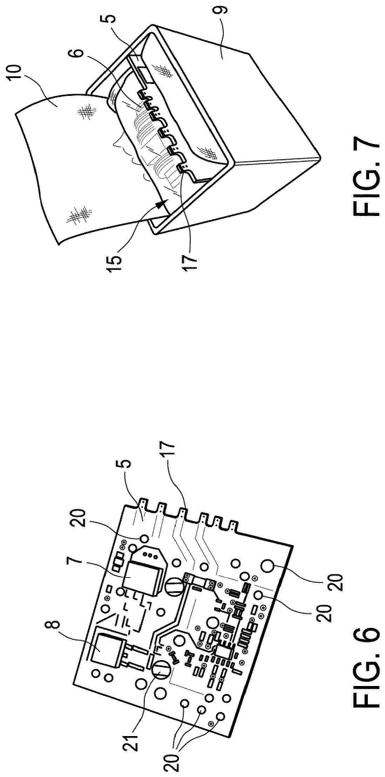

Fig. 1 zeigt einen Ausschnitt eines Teils einer Pumpenelektronik 1 einer nicht dargestellten elektromotorisch angetriebenen Kreiselpumpe. Die Pumpenelektronik 1 weist ein Elektronikgehäuse 2 auf, von dem hier lediglich ein wannenförmiges Unterteil darstellt ist. Dieses ist aus Metall, insbesondere Aluminium hergestellt und beherbergt in seinem Inneren eine Steuer- und/ oder Regelungselektronik. Auf dem Unterteil ist im fertig montierten Zustand der Pumpenelektronik 1 ein Deckel aufgesetzt, der die Steuer- und/ oder Regelungselektronik abdeckt. Die Steuer- und/ oder Regelungselektronik umfasst einen Frequenzumrichter zur Drehzahlregelung der Kreiselpumpe sowie eine PFC-Schaltung (Power Factor Control) zur Filterung von Oberwellen, die durch den Frequenzumrichter verursacht werden und in das speisende Wechsel- oder Drehspannungsnetz rückwirken. Ein Großteil der elektrischen und elektronischen Bauelemente der Steuer- und/ oder Regelungselektronik ist auf einer nicht dargestellten Leiterplatte (Motorplatine) angeordnet, die sich parallel zum Boden des Unterteils erstreckt und in diesem einliegt. Demgegenüber ist ein Teil der Bauelemente, die abzuführende Wärme und elektromagnetische Interferenzen (EMI, Elektromagnetic Interference) erzeugen, auf einer separaten Leiterplatte 5 angeordnet. Diese Bauelemente umfassen in dieser Ausführungsvariante die zur PFC-Schaltung gehörende Drossel 6 (Fig. 2) sowie Halbleiterschalter 7, 8 (Fig. 6) in Form von Dioden 7 und Transistoren 8 (MOSFETS).

Um eine effektive Kühlung und EMV Abschirmung von Wärme und Interferenzen erzeugenden Bauelementen sicherzustellen, ist erfindungsgemäß vorgesehen, dass die Bauelemente 6, 7, 8 mitsamt der Leiterplatte 5 in einer thermisch leitfähigen Vergussmasse 4 eingebettet sind und gemeinsam einen Vergusskörper 3 bilden. Dieser Vergusskörpers 3 ist innerhalb des Elektronikgehäuses 3 angeordnet und weist eine integrierte Abschirmung 8 auf. Somit bildet der Vergusskörper 3 eine hochintegrierte Funktionsbaugruppe, die einerseits die Fertigung der Pumpenelektronik vereinfacht, andererseits eine wirkungsvolle Kühlung und EMI Abschirmung bewirkt. Durch die vollflächige Ummantelung der Bauelemente 6, 7, 8 von der wärmeleitenden Vergussmasse wird erzeugte Wärme unmittelbar von der Vergussmasse aufgenommen und von den Bauelementen abgeführt. Durch die integrierte elektromagnetische Abschirmung sind die Bauelemente quasi eingekapselt. Interferenzen werden auf den Ort der Entstehung begrenzt und können sich nicht erst in den übrigen Bereich der Pumpenelektronik 1 ausbreiten.

Um die Wärme von dem Vergusskörper 3 abzuführen, liegt dieser flächig an einer metallischen Wand 18 des Elektronikgehäuses 2 an. Die Wand 18 bildet hier eine Wärmesenke. Die Vergussmasse 4 ist elektrisch isolierend, so dass die vor der Montage frei zugänglichen spannungsführenden Teile der Bauelemente gefahrlos mit der Vergussmasse in Kontakt gelangen können. Durch die Vergussmasse 4 sind die Bauelemente außerdem vor Feuchtigkeit geschützt und ortsfest derart fixiert, dass sie sich nicht infolge von Vibrationen und Stößen bewegen können, die vor allem beim Transport der Pumpe zum Kunden, aber auch im Betrieb auftreten.

Fig. 2 und 3 zeigen weitere Ausführungsvarianten des Vergusskörpers 3. Bei den Ausführungsvarianten in den Fig. 1 und 2 weist der Vergusskörper 3 ein becherförmiges Modulgehäuse 9 auf, während der Vergusskörper 3 in der Ausführungsvariante nach Fig. 3 gehäuselos ist, so dass die ausgehärtete Vergussmasse nach außen freiliegt. Das Modulgehäuse 9 ist aus einem thermisch leitfähigen, thermoplastischen Kunststoff spritzgegossen. Es ist von der Grundform quaderförmig, kann jedoch auch anders geformt sein. Allerdings ist es von Vorteil, wenn die Form zumindest eine ebene Wand aufweist, um das Modulgehäuse an eine Wärmesenke anlegen zu können, deren Kühlflächen üblicherweise ebenfalls eben ausgebildet sind. Innerhalb des Modulgehäuses 9 sind die Leiterplatte 5 mit den Bauelementen 6, 7, 8 mit der Vergussmasse 4 vergossen. Ein Teil der Leiterplatte 5 ragt aus der Vergussmasse 4 heraus. An diesem Teil stellt die Leiterplatte 5 elektrische Anschlüsse in Form von Kontaktflächen 17 bereit. Die Anschlüsse 17 sind kammartig ausgebildet, indem zwischen zwei benachbarten Kontaktflächen Ausnehmungen in der Leiterplatte 5 vorliegen.

Die Herstellung des Vergusskörpers 3 gemäß Fig. 1 und 2 erfolgt derart, dass zunächst das Modulgehäuse 9 in einer Spritzgussmaschine herstellt wird, vorzugsweise aus einem thermoplastischen Kunststoff, der idealerweise auch thermisch leitfähig und EMV abschirmend ist. Parallel wird die Leiterplatte 5 mit den Bauelementen 6, 7, 8 konfektioniert, wobei die Drossel 6 auf einer Seite der Leiterplatte 5 und die Dioden 7 und Transistoren 8 auf der anderen Seite angeordnet werden. Die Drossel 6 ist in Form einer Ringkernspule ausgebildet und liegt flach auf der Leiterplatte 5, so dass eine kompakte Anordnung erreicht wird. Anschließend wird die konfektionierte Leiterplatte 5 durch die Öffnung 15 in das Modulgehäuse 9 eingesetzt und darin mit der Vergussmasse 4 vergossen, wobei die Vergussmasse 4 drucklos durch die Öffnung 15 in das Modulgehäuse 9 gegossen wird. Das Modulgehäuse 9 bildet somit gleichzeitig auch die Gießform für die Vergussmasse.

In der Ausführungsvariante gemäß Fig. 1 ist zusätzlich ein Einlegeteil 14 im Modulgehäuse 9 vergossen. Dieses ist hier durch ein Metallblech gebildet und ragt mit einem Abschnitt 16 aus der Vergussmasse 4 heraus. Aufgrund des hohen Wärmeleitkoeffizienten führt es die Wärme besonders effektiv aus der Vergussmasse 4 heraus, so dass das Modulgehäuse 9 nicht aus einem thermisch leitfähigen Kunststoff bestehen muss. Der Abschnitt 16 bildet hier quasi eine Fahne, mit welcher das Einlegeteil 14 mittels Schrauben an der Wand 18 mechanisch befestigt und mit dieser in thermisch leitender Verbindung steht.

Die Herstellung des Vergusskörpers 3 gemäß Fig. 3 erfolgt derart, dass zunächst die Leiterplatte 5 mit den Bauelementen 6, 7, 8 konfektioniert wird, wobei auch hier die Drossel 6 auf der einen und die Dioden 7 und Transistoren 8 auf der anderen Seite der Leiterplatte 5 angeordnet werden. Ebenfalls ist hier die Drossel 6 in Form einer Ringkernspule ausgebildet und liegt flach auf der Leiterplatte 5, so dass eine kompakte Anordnung erreicht wird. Anschließend wird die konfektionierte Leiterplatte 5 in die Gießform oder Spritzgießform eines Gieß- oder Spritzgießwerkzeugs eingelegt, welches anschließend die Vergussmasse 4 drucklos oder mit einem entsprechenden Spritzdruck, je nach Viskosität der Vergussmasse 4 in die Gießform oder Spritzgießform einfüllt. Die Gieß- oder Spritzgießform hat hier ebenfalls eine Quaderform, so dass auch der Vergusskörper 3 letztendlich quaderförmig wird. Der aufgespritzte Kunststoff kann ein Thermoplast sein, vorzugsweise mit thermischer Leitfähigkeit.

Die Herstellung eines Vergusskörpers 3 mit Gehäuse kann gemäß einer weiteren Ausführungsvariante auch derart erfolgen, dass zunächst wie beschrieben der Vergusskörper 3 in der Gießform oder Spritzgießform eines Gieß- oder Spritzgießwerkzeugs erzeugt wird und anschließend nach Verfestigung der Vergussmasse 4 ein weiterer Kunststoff um die Vergussmasse 4 herum gespritzt wird, der das Modulgehäuse 9 bildet. Dies kann mit dem sogenannten 2K-Spritzgießverfahren (Zweikomponenten) realisiert werden.

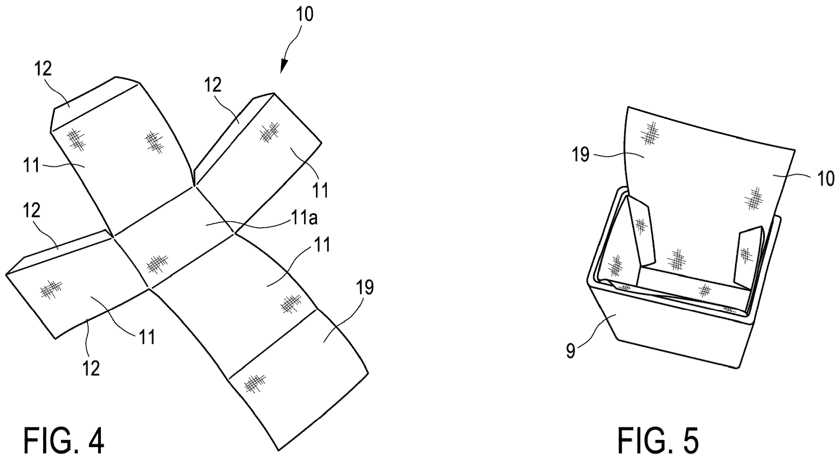

Figuren 4 bis 7 zeigen eine weitere Ausführungsvariante des Vergusskörpers 3, bei welchem die Abschirmung durch ein metallisches Vlies 10 gebildet ist. Das Vlies 10 ist in dieser Variante vor dem Vergießen der Bauelemente 6, 7, 8 in das Modulgehäuse 9 in gefalteter Form eingelegt, wie dies in Fig, 5 zu erkennen ist. Durch die Vergussmasse 4 wird das Vlies 10 gegen die Innenseite des Modulgehäuses 9 gedrückt, so dass es nach dem Vergießen zwischen der Vergussmasse 4 und dem Modulgehäuse 9 liegt, allerdings von der Vergussmasse 4 benetzt ist.

Es ist alternativ möglich, das Vlies 10 in die Spritzgießform für das Modulgehäuse 9 einzulegen und das Modulgehäuse 9 an das Vlies 10 anzuspritzen. Dabei kann das Vlies innen- oder außenseitig am Modulgehäuse 9 anliegen. Liegt es innenseitig, so ist das Vlies 10 im Endzustand des Vergusskörpers 3 ebenfalls zwischen der Vergussmasse 4 und dem Modulgehäuse 9 angeordnet, jedoch ist das Vlies 10 nicht von der Vergussmasse 4, sondern von dem Kunststoff des Modulgehäuses 9 benetzt.

Weiter alternativ ist es auch möglich, das Vlies 10 in die Gieß- oder Spritzgießform zur Herstellung des gehäuselosen Vergusskörpers 3 einzulegen. Da das Vlies 10 von der Vergussmasse 4 nicht oder kaum durchdrungen wird, wird es gegen die Wand der Form gedrückt und liegt dann im ausgehärteten Zustand der Vergussmasse 4 außen am Vergusskörper 3 an.

Fig. 4 zeigt das metallische Vlies 10 als Flächengebilde, das entsprechend der Innenform des Modulgehäuses zurechtgeschnitten ist. Es ist aus zusammenhängenden Flächenabschnitten 11 gebildet, die in Größe und Form jeweils einer Innenwand des Modulgehäuses 9 entsprechen und an jeweils einem Falz ineinander übergehen, an der das Vlies 10 später gefaltet wird. Von einem zentralen Flächenabschnitt 11a, der am Boden des Modulgehäuses 9 zum Anliegen kommt, erstrecken sich zu allen vier Seiten jeweils ein weiterer Flächenabschnitt 11. Ein Teil dieser Flächenabschnitte 11 weist an einer oder mehreren Seitenkanten seitliche Laschen 12 auf, die im gefalteten, im Modulgehäuse 9 einliegenden Zustand die benachbarten Flächenabschnitte 11 überlappen. Dies verhindert, dass elektromagnetische Strahlung an den Seitenkanten des Vergusskörpers 3 austritt. An einen Flächenabschnitt 11 schließt sich ein weiterer Flächenabschnitt 19 an, der bestimmungsgemäß aus dem Modulgehäuse 9 hervorsteht, wie in Fig. 5 zu erkennen ist. Dieser hervorstehende Flächenabschnitt 19 kann nach dem Einsetzen der Leiterplatte 5 mitsamt der Bauelemente 6, 7, 8 umgeklappt werden, um die Öffnung 15 des Modulgehäuses zumindest teilweise zu verschließen, so dass seitens der Öffnung 15 keine elektromagnetische Strahlung austritt. Das Umklappen erfolgt nach dem Vergießen der Bauelemente 6, 7, 8. In gleicher Weise kann auf der gegenüberliegenden Seite eine Lasche 12 aus dem Modulgehäuse 9 hervorstehen, die ebenfalls dafür vorgesehen ist, einen Teil der Öffnung 15 zu verschließen.

Fig. 6 zeigt die mit den Bauelementen 7, 8 bestückte Leiterplatte 5, die in das Modulgehäuse 9 einzusetzen ist, wie dies auch bei den Figuren 1 und 2 der Fall ist. Die Leiterplatte 5 umfasst eine gedruckte Schaltung (PCB) mit Leiterbahnen, welche zumindest einen Teil der Bauelemente miteinander verbinden. Zu erkennen sind in Fig. 6 Durchtrittsöffnungen 20, die ein Durchströmen der Vergussmasse 4 ermöglichen und somit deren schnelle und blasenfreie Verteilung begünstigen.

Halteelemente 21 für die Halterung der Drossel 9 greifen mittels Rastnasen in entsprechende Halteöffnungen ein.

Wie Fig. 7 veranschaulicht, wird die Leiterplatte 5 bestimmungsgemäß rechtwinklig zur Öffnung 15 in das Modulgehäuse 9 eingesetzt, wobei die randseitigen Anschlusskontakte 17 aus dem Modulgehäuse 9 herausragen. In diesem Zustand erfolgt das Vergießen der Leiterplatte 5 und der Bauelemente 6, 7, 8.

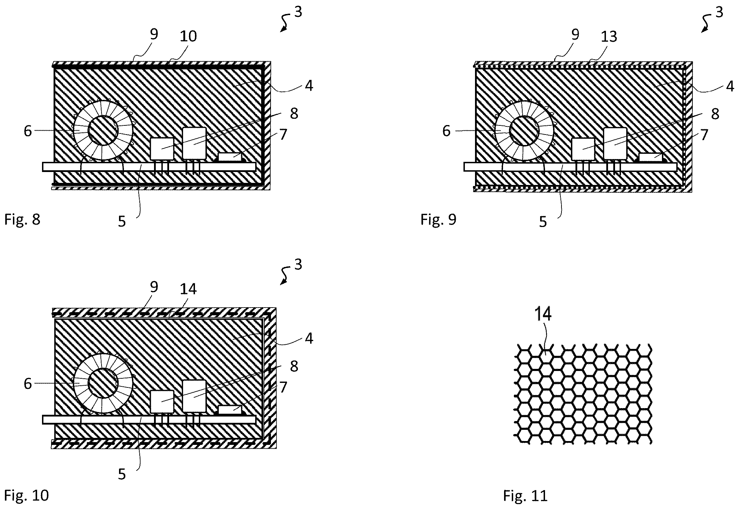

Figuren 8 bis 16 zeigen unterschiedliche Realisierungsvarianten für die elektromagnetische Abschirmung anhand eines Vergusskörpers, der lediglich als Prinzipdarstellung gezeigt ist. Wie zuvor sind hier eine Drossel 6, sowie Halbleiterbauelemente 7, 8, insbesondere Halbleiterschalter auf einer Leiterplatte 5 angeordnet.

Fig. 8 entspricht im Wesentlichen der in den Figuren 5 und 6 gezeigten Ausführungsvariante, bei der die Abschirmung durch ein metallisches Vlies 10 gebildet ist. Der Vergusskörper 3 ist hier mit einem Modulgehäuse 9 versehen, wobei das Vlies 10 zwischen der Vergussmasse 4 und dem Modulgehäuse 9 liegt. Wie zuvor beschrieben, kann das Vlies 10 entweder bei der Herstellung des Modulgehäuses 9 zu dessen Bestandteil geworden sein oder, wie in Fig. 5, beim Vergießen der Bauelemente in dem Vergusskörper 3 eingebettet worden sein. Die Vergussmasse 4 ist aus einem elektrisch isolierendem, thermisch leitfähigem Kunststoffpolymer, insbesondere einem Duroplast. Der Kunststoff des Modulgehäuses 9 ist ebenfalls thermisch leitfähig, insbesondere ein Thermoplast.

Alternativ zu der Variante in Fig. 8 kann das Vlies 10 außen am Modulgehäuse 9 anliegen.

Bei der Ausführungsvariante in Fig. 9 ist die Abschirmung durch eine elektrisch leitende, insbesondere metallische Beschichtung 13 innenseitig des Modulgehäuses 9 gebildet. Alternativ kann sie auch außen auf das Modulgehäuse 9 aufgetragen sein. Im Übrigen entspricht diese Variante derjenigen in Fig. 8.

Bei der Ausführungsvariante in Fig. 10 ist die Abschirmung durch ein metallisches Einlegeteil 14 gebildet, das in dem Kunststoff des Modulgehäuses 9 eingebettet ist. Es liegt hier ausschließlich in diesem Kunststoff ein, erstreckt sich also nicht in den Innenraum des Modulgehäuses 9, so dass es nicht mit der Vergussmasse 4 in Kontakt steht. Gleichwohl kann dies in einer Ausführungsvariante ebenfalls möglich sein, so dass es teilweise in dem Kunststoff des Modulgehäuses 9, und teilweise in der Vergussmasse eingebettet ist. Das Einlegeteil 14 kann beispielsweise ein Gitter, ein Lochblech, ein Netz oder ein Gewebe sein. Es ist vorzugsweise formstabil und weist Maschen auf, durch welche der Kunststoff hindurchdringen kann. Fig. 11 zeigt ein Beispiel des Einlegeteils 14 in Form eines wabenförmigen Netzes.

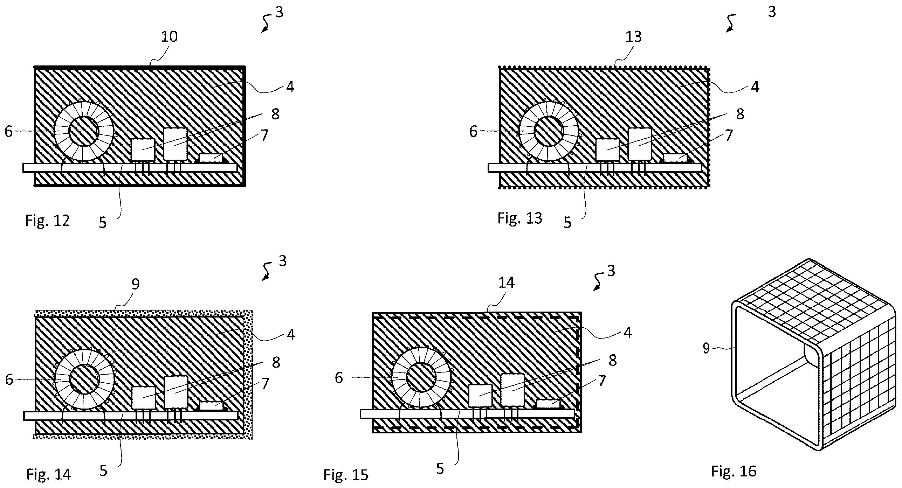

Fig. 12 zeigt einen gehäuselosen Vergusskörper 3 gemäß Fig. 3, der hier jedoch außenseitig mit einem Vlies 10 als elektromagnetische Abschirmung versehen ist.

Fig. 13 zeigt ebenfalls einen gehäuselosen Vergusskörper 3 gemäß Fig. 3, der hier außenseitig mit einer elektrisch leitenden, insbesondere metallischen Beschichtung 13 als elektromagnetische Abschirmung versehen ist.

Fig. 14 zeigt einen Vergusskörper 3 mit Modulgehäuse 9 das Partikel aufweist, die eine elektromagnetische Abschirmung bewirken. Die Vergussmasse 4 besteht aus einem elektrisch isolierenden und thermisch leitfähigen Kunststoffpolymer, insbesondere einem Duroplast. Sie besitzt jedoch keine Abschirmungseigenschaften. Der Kunststoff des Modulgehäuses 9 ist wie zuvor zusätzlich zur Abschirmungseigenschaft thermisch leitfähig, insbesondere ein Thermoplast.

Fig. 15 zeigt einen gehäuselosen Vergusskörper 3 gemäß Fig. 3, bei dem die Abschirmung ebenfalls durch ein metallisches Einlegeteil 14 gebildet ist. Dieses ist hier in der Vergussmasse 4 eingebettet, wie dies auch in Fig. 1 der Fall ist, bei der der Vergusskörper 3 ein Modulgehäuse 9 aufweist. Das Einlegeteil 14 kann beispielsweise ein Gitter, ein Lochblech, ein Netz oder ein Gewebe sein. Es ist vorzugsweise formstabil und weist Maschen auf, durch welche die Vergussmasse 4 hindurchdringen kann. Das Beispiel in Fig. 11 in Form eines wabenförmigen Netzes kann hier ebenfalls das Einlegeteil 14 bilden.

Fig. 16 zeigt ein Modulgehäuse 9, bei dem als Abschirmung außenseitig Leiterbahnen aufgetragen sind. Diese bilden eine Netzförmige Struktur. Der Herstellung der Leiterbahnen kann durch die sogenannte IMKS-Technik erfolgen. Alternativ können diese Leiterbahnen auch innenseitig auf das Modulgehäuse 9 aufgetragen sein. Weiter alternativ können die Leiterbahnen außenseitig auf die gehäuselose Vergussmasse 4 aufgetragen sein. Die Leiterbahnen auf dem Modulgehäuse 9 oder auf der Vergussmasse können zudem zur Wärmeleitung dienen.

Bei den Varianten in Fig. 10 und 15 kann vorgesehen sein, dass das Einlegeteil 14 aus dem Vergusskörper 3 mit einem Abschnitt 16 herausragt, wie dies in Fig. 1 der Fall ist. Das Einlegeteil 14 dient dabei sowohl zur Herausleitung der Wärme aus dem Vergusskörper 3, als auch als mechanische Befestigungsmöglichkeit und elektrische Anschlussmöglichkeit. Um die Abschirmung zu verbessern, kann das Einlegeteil 14 mit Masse verbunden werden. Dies kann vorzugsweise durch die Verschraubung mit der Wand 18 des Elektronikgehäuses 2 erfolgen, die dann nicht nur eine Wärmesenke, sondern gleichzeitig auch als Erdung dient.

Bei sämtlichen Varianten ist vorgesehen, dass die Leiterplatte 5 mit Kontakten 17 wie beispielsweise Kontaktpads aus der Vergussmasse 4 bzw. dem Vergusskörper 3 herausragt. Alternativ können auch andere Kontakte wie z.B. stiftförmige Kontakte verwendet werden, die aus der Vergussmasse 4 herausragen und die Leiterplatte 5 kontaktieren, während die Leiterplatte 5 vollständig vergossen ist. Damit die Kontakte nicht vom Kunststoff benetzt werden, ist es vorteilhaft, diese während des Vergießens oder Umspritzens der Bauelemente 6, 7, 8 mit einem Dichtelement abzudichten.

Um die Bauelemente 6, 7, 8 durch den Spritzdruck nicht zu beschädigen, sollte das Einspritzen der Vergussmasse 4 derart erfolgen, dass der Spritzstrahl nicht direkt auf die Bauelemente 6, 7, 8 gerichtet ist. Geeigneterweise wird der Spritzstrahl auf die Leiterplatte oder die Kavitäts- oder Modulgehäuseinnenwand gerichtet.

Mit der vorliegenden Erfindung wird eine elektromagnetisch geschirmte, wärmeleitfähige, polytronische Baugruppe mit integrierten Spulen, Wickelgütern, Halbleitern und/ oder Sensoren, insbesondere mit Bauelementen der Leistungselektronik einer Pumpe, wie z.B. der PFC-Schaltung bereitgestellt. Die Baugruppe kann die PFC-Drossel und Halbleiterschalter auf einer Leiterplatte umfassen, mit wärmeleitfähiger Vergussmasse umhüllt, und mit integrierter EMV-Abschirmung, die ggf. zusätzlich auch noch zur Wärmeabfuhr dient, z.B. indem die Abschirmung ein Einlegeteil (Lochblech) mit Fahne nach außen ist. Hierdurch ergeben sich weniger Montageschritte.

Durch die Kombination von kleinen SMD-Bauteilen mit großen Elektronikkomponenten (PFC-Drossel) ergibt sich eine kompaktere Bauform. Bisher waren Hableiter und Drossel (Komponente einer Funktionsgruppe) räumlich auf der Leiterplatte weit auseinander. Hauptsächlich wegen unterschiedlicher Handhabung der Bauteile (u.a. unterschiedlicher Lötprozesse wie THT und SMD).

Durch die Verwendung einer wärmeleitfähigen Vergussmasse (Polymer Material) und die direkte thermische Anbindung an das metallische Unterteil des Elektronikgehäuses 2 wird eine bessere Kühlung erreicht. Ferner ergibt sich eine Kosteneinsparung, da kleinere Bauteile verwendet werden können. Insgesamt wird eine Steigerung der Leistungsfähigkeit der Elektronikkomponenten erreicht.

Eine Vorkonfektionierung der Drossel 6 entfällt, so dass die Fertigung vereinfacht wird. Design-Loops für EMV-gerechtes Design können eingespart werden. Zusätzliche Bauteile, die teilweise für ein EMV-gerechtes Design notwendig wären, können eingespart werden. Ein weiterer Vorteil besteht darin, dass die erfindungsgemäße Lösung skalierbar ist, so dass je nach Bedarf mehr oder weniger Komponenten in den Vergusskörper 3 aufgenommen werden können.

### Bezugszeichenliste

- 1: Pumpenelektronik
- 2: Elektronikgehäuse
- 3: Vergusskörper
- 4: Vergussmasse
- 5: Leiterplatte
- 6: Drossel
- 7: Dioden, Gleichrichter
- 8: Transistoren
- 9: Modulgehäuse
- 10: Metallisches Vlies
- 11: Flächenabschnitt
- 11a: zentraler Flächenabschnitt
- 12: Lasche
- 13: Beschichtung
- 14: Einlegeteil
- 15: Öffnung des Modulgehäuses
- 16: Abschnitt, Fahne
- 17: Elektrische Kontaktflächen
- 18: Wand
- 19: Hervorstehender Flächenabschnitt
- 20: Durchtrittsöffnungen
- 21: Halteelemente

## Patentansprüche

1. Pumpenelektronik (1) einer elektromotorisch angetriebenen Kreiselpumpe mit einem Elektronikgehäuse (2), in dem eine Steuer- und/ oder Regelungselektronik mit einem Frequenzumrichter zur Drehzahlregelung der Kreiselpumpe angeordnet ist, wobei die Steuer- und/oder Regelungselektronik zumindest eine Leiterplatte (5) mit elektrischen und/oder elektronischen Bauelementen (6, 7, 8) aufweist, die wenigstens eine Drossel (6) und Halbleiterschalter (7, 8) umfassen und von einer elektromagnetischen Abschirmung (10, 13, 14) umgeben sind, **dadurch gekennzeichnet, dass** die Bauelemente (6, 7, 8) mitsamt der Leiterplatte (5) in einer thermisch leitfähigen Vergussmasse (4) eingebettet sind und gemeinsam einen Vergusskörper (3) bilden, der innerhalb des Elektronikgehäuses (2) angeordnet ist, wobei die Abschirmung (10, 13, 14) in den Vergusskörper (3) integriert ist.

2. Pumpenelektronik (1) nach Anspruch 1, **dadurch gekennzeichnet, dass** der Vergusskörper (3) ein becherförmiges, aus einem Kunststoff, insbesondere aus einem thermisch leitfähigen Kunststoff, spritzgegossenes Modulgehäuse (9) aufweist, innerhalb welchem die Bauelemente (6, 7, 8) mit der Vergussmasse (4) vergossen sind.

3. Pumpenelektronik (1) nach Anspruch 2, **dadurch gekennzeichnet, dass** die Abschirmung durch ein metallisches Vlies (10) gebildet ist, an welches das Modulgehäuse (9) angespritzt ist, so dass es innen- oder außenseitig am Modulgehäuse (9) anliegt, oder welches vor dem Vergießen der Bauelemente (6, 7, 8) in das Modulgehäuse (9) eingelegt ist, so dass es zwischen der Vergussmasse (4) und dem Modulgehäuse (9) liegt.

4. Pumpenelektronik (1) nach Anspruch 3, **dadurch gekennzeichnet, dass** das Vlies (10) die Form und Größe des Innenraums des Modulgehäuses (9) nachbildend gefaltet in dem Modulgehäuse (9) einliegt, wobei seitliche Laschen (12) von Flächenabschnitten (11) des Vlieses (10) andere Flächenabschnitte (11) des Vlieses (10) überlappen.

5. Pumpenelektronik (1) nach einem der Ansprüche 2 bis 4, **dadurch gekennzeichnet, dass** die Abschirmung durch eine elektrisch leitende Beschichtung (13) oder durch Leiterbahnen, insbesondere ein Netz von Leiterbahnen (14) gebildet ist, die innen- und/oder außenseitig auf das Modulgehäuse (9) aufgebracht ist/ sind.

6. Pumpenelektronik (1) nach Anspruch 2 bis 5, **dadurch gekennzeichnet, dass** die Abschirmung durch ein metallisches Einlegeteil (14), insbesondere in Form eines Gitters, Lochblechs, Netzes oder Gewebes, gebildet ist, das durch das Spritzgießen des Modulgehäuses (9) in den das Modulgehäuse (9) bildenden Kunststoff eingebettet ist.

7. Pumpenelektronik (1) nach einem der Ansprüche 2 bis 6, **dadurch gekennzeichnet, dass** der das Modulgehäuse (9) bildende Kunststoff Partikel enthält, die die elektromagnetische Abschirmung bewirken.

8. Pumpenelektronik (1) nach einem der Ansprüche 2 bis 7, **dadurch gekennzeichnet, dass** die Leiterplatte (5) rechtwinklig zu einer Öffnung (15) des Modulgehäuses (9) angeordnet ist, durch die die Leiterplatte (5) in das Modulgehäuse (9) eingesetzt ist.

9. Pumpenelektronik (1) nach einem der Ansprüche 2 bis 8, **dadurch gekennzeichnet, dass** die Leiterplatte (5) aus einer Öffnung (15) des Modulgehäuses (9) mit elektrischen Kontaktflächen (17) herausragt.

10. Pumpenelektronik (1) nach einem der vorherigen Ansprüche, **dadurch gekennzeichnet, dass** der Vergusskörper (3) flächig an zumindest einer metallischen Wand (18) des Elektronikgehäuses (2) thermisch leitend anliegt.

11. Pumpenelektronik (1) nach Anspruch 1 oder 10, **dadurch gekennzeichnet, dass** der Vergusskörper (3) gehäuselos ausgebildet ist.

12. Pumpenelektronik (1) nach Anspruch 11, **dadurch gekennzeichnet, dass** die Abschirmung durch ein metallisches Vlies (10) gebildet ist, das mit der Vergussmasse (4) derart vergossen ist, dass es außenseitig am Vergusskörper (3) anliegt.

13. Pumpenelektronik (1) nach Anspruch 11 oder 12, **dadurch gekennzeichnet, dass** die Abschirmung durch eine elektrisch leitende Beschichtung (13) oder durch Leiterbahnen, insbesondere ein Netz von Leiterbahnen (14) gebildet ist, die außenseitig auf den Vergusskörper (3) aufgebracht ist/ sind.

14. Pumpenelektronik (1) nach einem der Ansprüche 11 bis 13, **dadurch gekennzeichnet, dass** die Abschirmung durch ein metallisches Einlegeteil (14), insbesondere in Form eines Gitters, Lochblechs, Netzes oder Gewebes, gebildet ist, das durch das Vergießen der Bauelemente (6, 7, 8) in der Vergussmasse (4) eingebettet ist.

15. Pumpenelektronik (1) zumindest nach Anspruch 6 oder 14, **dadurch gekennzeichnet, dass** das Einlegeteil (14) mit einem Abschnitt (16) aus dem Vergusskörper (3) hervorsteht.

16. Pumpenelektronik (1) nach Anspruch 15, **dadurch gekennzeichnet, dass** das Einlegeteil (14) dem Abschnitt (16) thermisch leitend mit einer Wärmesenke, insbesondere mit einer metallischen Wand (18) des Elektronikgehäuses (2) verbunden, vorzugsweise verschraubt ist, und/ oder dass das Einlegeteil (14) über den Abschnitt (16) elektrisch mit Masse verbunden ist.

17. Pumpenelektronik (1) nach einem der vorherigen Ansprüche, **dadurch gekennzeichnet, dass** die Drossel (6) liegend auf der Leiterplatte (5) montiert ist.

18. Pumpenelektronik (1) nach einem der vorherigen Ansprüche, **dadurch gekennzeichnet, dass** die Leiterplatte (5) Durchtrittsöffnungen (20) für das Hindurchtreten der Vergussmasse (4) beim Vergießen der Bauelemente (6, 7, 8) aufweist.

19. Pumpenelektronik (1) zumindest nach Anspruch 11, **dadurch gekennzeichnet, dass** der Vergusskörper (3) in seinem Inneren mitvergossene Halteelemente (21) zur ortsfesten Halterung der Leiterplatte (5) in einer Gießform oder Spritzgießform eines Gießwerkzeugs aufweist.

## Claims

1. Pump electronics(1) of an electric motor driven centrifugal pump with an electronics housing (2) containing open loop and/or closed loop control electronics with a frequency converter to control the rotational speed of the centrifugal pump, in which the open loop and/or closed loop control electronics have at least one PCB (5) with electrical and/or electronic components (6, 7, 8), comprising at least one inductor (6) and semiconductor switch (7, 8) and surrounded by electromagnetic shielding (10, 13, 14), **characterised by** the components (6, 7, 8) with the PCB (5) being embedded in a thermally conductive compound (4) and jointly forming a cast body (3) arranged within the electronics housing (2), in which the shielding (10, 13, 14) is integrated into the cast body (3).

2. Pump electronics (1) according to claim 1, **characterised by** the cast body (3) having a cup-shaped, injection-moulded module housing made of plastic, notably thermally conductive plastic (9), within which the components (6, 7, 8) are cast with the compound (4).

3. Pump electronics (1) according to claim 2, **characterised by** the shielding being formed by a metallic mat (10) to which the module housing (9) is moulded so that it abuts the inside or outside of the module housing (9), or that is inserted into the module housing (9) before casting the components (6, 7, 8) so that it lies between the compound (4) and the module housing (9).

4. Pump electronics (1) according to claim 3, **characterised by** the mat (10) being folded according to the shape and size of the module housing (9) and lying in the module housing (9), with lateral flaps (12) of surface sections (11) of the mat (10) overlapping other surface sections (11) of the mat (10).

5. Pump electronics (1) according to one of the claims 2 through 4, **characterised by** the shielding being formed by an electrically conductive coating (13) or by PCB tracks, notably a network of PCB tracks (14) applied to the inside and/or outside of the module housing (9).

6. Pump electronics (1) according to claims 2 through 5, **characterised by** the shielding being formed by a metallic insert (14), notably in the form of a grate, perforated plate, grid or mesh, which is embedded in the plastic forming the module housing (9) during the injection moulding the module housing (9).

7. Pump electronics (1) according to one of the claims 2 through 6, **characterised by** the plastic forming the module housing (9) containing particles effecting electromagnetic shielding.

8. Pump electronics (1) according to one of the claims 2 through 7, **characterised by** the PCB (5) being arranged perpendicular to an opening (15) in the module housing (9) through which the PCB (5) is inserted into the module housing (9).

9. Pump electronics (1) according to one of the claims 2 through 8, **characterised by** the PCB (5) projecting from an opening (15) in the module housing (9) with electrical contact surfaces (17).

10. Pump electronics (1) according to one of the preceding claims, **characterised by** the cast body (3) lying flat and thermally conductive against at least one metallic wall (18) of the electronics housing (2).

11. Pump electronics (1) according to claim 1 or 10, **characterised by** the cast body (3) being formed without a housing.

12. Pump electronics (1) according to claim 11, **characterised by** the shielding being formed by a metallic mat (10) that is cast with the compound (4) so that it lies against the outside of the cast body (3).

13. Pump electronics (1) according to claim 11 or 12, **characterised by** the shielding being formed by an electrically conductive coating (13) or by PCB tracks, notably a network of PCB tracks (14), applied to the outside of the cast body (3).

14. Pump electronics (1) according to one of the claims 11 through 13, **characterised by** the shielding being formed by a metallic insert (14), notably in the form of a grate, perforated plate, grid or mesh, which is embedded in the compound (4) by the casting of the components (6, 7, 8).

15. Pump electronics (1) according to at least claim 6 or 14, **characterised by** a segment (16) of the insert (14) projecting from the cast body (3).

16. Pump electronics (1) according to claim 15, **characterised by** the insert (14) having a thermally conductive connection to a heat sink, notably a metallic wall (18) of the electronics housing (2), via the segment (16), preferably a threaded connection, and/or the insert (14) having an electrical connection to earth via the segment (16).

17. Pump electronics (1) according to one of the preceding claims, **characterised by** the inductor (6) being mounted horizontally on the PCB (5).

18. Pump electronics (1) according to one of the preceding claims, **characterised by** the PCB (5) having openings (20) that allow the compound (4) to pass through during the casting of the components (6, 7, 8).

19. Pump electronics (1) according to at least claim 11, **characterised by** the cast body (3) having cast inner retaining elements (21) to hold the PCB (5) in place in a casting mould or an injection mould of a casting tool.

## Revendications

1. Électronique de pompe (1) d'une pompe centrifuge entraînée par un moteur électrique, avec un boîtier électronique (2) dans lequel est disposée une électronique de commande et/ou de régulation avec un convertisseur de fréquence pour la régulation de la vitesse de rotation de la pompe centrifuge, sachant que l'électronique de commande et/ou de régulation présente au moins un circuit imprimé (5) avec des composants électriques et/ou électroniques (6, 7, 8) composés d'au moins une bobine d'arrêt (6) et des commutateurs à semi-conducteurs (7, 8) et entourés d'un blindage électromagnétique (10, 13, 14), **caractérisée en ce que** les composants (6, 7, 8) sont noyés avec le circuit imprimé (5) dans une masse de scellement (4) thermiquement conductrice et forment ensemble un corps de scellement (3) disposé à l'intérieur du boîtier électronique (2), le blindage (10, 13, 14) étant intégré dans le corps de scellement (3).

2. Électronique de pompe (1) selon la revendication 1, **caractérisée en ce que** le corps de scellement (3) présente un boîtier de module (9) en forme de godet, moulé par injection dans une matière plastique, en particulier dans une matière plastique thermoconductrice, à l'intérieur duquel les composants (6, 7, 8) sont scellés avec la masse de scellement (4).

3. Électronique de pompe (1) selon la revendication 2, **caractérisée en ce que** le blindage est formé d'un non-tissé métallique (10) sur lequel le boîtier de module (9) est moulé par injection, de sorte qu'il s'applique sur le côté intérieur ou extérieur du boîtier de module (9), ou qui est inséré dans le boîtier de module (9) avant le scellement des composants (6, 7, 8), pour se trouver entre la masse de scellement (4) et le boîtier de module (9).

4. Électronique de pompe (1) selon la revendication 3, **caractérisée en ce que** le non-tissé (10) est plié dans le boîtier de module (9) en reproduisant la forme et la taille de l'espace intérieur du boîtier de module (9), sachant que des pattes latérales (12) de sections de surface (11) du non-tissé (10) recouvrent d'autres sections de surface (11) du non-tissé (10).

5. Électronique de pompe (1) selon l'une des revendications 2 à 4, **caractérisée en ce que** le blindage est formé d'un revêtement électroconducteur (13) ou de pistes conductrices, en particulier un réseau de pistes conductrices (14), appliqué(es) sur le boîtier du module (9) du côté intérieur et/ou extérieur.

6. Électronique de pompe (1) selon les revendications 2 à 5, **caractérisée en ce que** le blindage est formé par un insert métallique (14), notamment sous la forme d'une grille, d'une tôle perforée, d'un filet ou d'un tissu, noyé dans la matière plastique formant le boîtier de module (9) par le moulage par injection du boîtier de module (9).

7. Électronique de pompe (1) selon l'une des revendications 2 à 6, **caractérisée en ce que** le plastique composant le boîtier de module (9) contient des particules générant le blindage électromagnétique.

8. Électronique de pompe (1) selon l'une des revendications 2 à 7, **caractérisée en ce que** le circuit imprimé (5) est disposé à angle droit par rapport à une ouverture (15) du boîtier de module (9), au travers de laquelle le circuit imprimé (5) est intégré au boîtier de module (9).

9. Pompe centrifuge (1) selon l'une des revendications 2 à 8, **caractérisée en ce que** le circuit imprimé (5) dépasse d'une ouverture (15) du boîtier de module (9) avec des surfaces de contact électrique (17).

10. Électronique de pompe (1) selon l'une des revendications précédentes, **caractérisée en ce que** le corps de scellement (3) repose de manière thermoconductrice sur la surface d'au moins une paroi métallique (18) du boîtier électronique (2).

11. Électronique de pompe (1) selon la revendication 1 ou 10, **caractérisée en ce que** le corps de scellement (3) est réalisé sans boîtier.

12. Électronique de pompe (1) selon la revendication 11, **caractérisée en ce que** le blindage est formé d'un non-tissé métallique (10) scellé avec la masse de scellement (4) de telle sorte qu'il s'applique du côté extérieur contre le corps de scellement (3).

13. Électronique de pompe (1) selon la revendication 11 ou 12, **caractérisée en ce que** le blindage est formé d'un revêtement électroconducteur (13) ou de pistes conductrices, en particulier un réseau de pistes conductrices (14), appliqué(es) sur le boîtier du module (3) du côté extérieur.

14. Électronique de pompe (1) selon l'une des revendications 11 à 13, **caractérisée en ce que** le blindage est formé par un insert métallique (14), notamment sous la forme d'une grille, d'une tôle perforée, d'un filet ou d'un tissu, noyé dans la masse de scellement (4) par le moulage par injection des composants (6, 7 8).

15. Électronique de pompe (1) selon au moins la revendication 6 ou 14, **caractérisée en ce que** l'insert (14) dépasse d'une section (16) du corps de scellement (3).

16. Électronique de pompe (1) selon la revendication 15, **caractérisée en ce que** l'insert (14) est relié, de préférence vissée, de manière thermoconductrice à la section (16) avec un puits thermique, en particulier avec une paroi métallique (18) du boîtier électronique (2), et/ou **en ce que** l'insert (14) est relié électriquement à la masse par la section (16).

17. Électronique de pompe (1) selon l'une des revendications précédentes, **caractérisée en ce que** la bobine d'arrêt (6) fait partie intégrante du circuit imprimé (5).

18. Électronique de pompe (1) selon l'une des revendications précédentes, **caractérisée en ce que** le circuit imprimé (5) présente des ouvertures de passage (20) pour le passage de la masse de scellement (4) lors du scellement des composants (6, 7, 8).

19. Électronique de pompe (1) selon au moins la revendication 11, **caractérisée en ce que** le corps de scellement (3) présente, à l'intérieur des éléments de maintien (21) coulés avec lui destinés à maintenir fixement le circuit imprimé (5) dans un moule de coulée ou un moule d'injection d'un outil de coulée.
